(19) Europäisches Patentamt / European Patent Office / Office européen des brevets

(11) **EP 1 969 166 B1**

(12) **EUROPÄISCHE PATENTSCHRIFT**

(45) Veröffentlichungstag und Bekanntmachung des Hinweises auf die Patenterteilung:
**10.06.2009 Patentblatt 2009/24**

(21) Anmeldenummer: 06830220.7

(22) Anmeldetag: **30.11.2006**

(51) Int Cl.:
*D01D 5/00* (2006.01)   *H01L 35/14* (2006.01)
*H01L 35/34* (2006.01)

(86) Internationale Anmeldenummer:
**PCT/EP2006/069116**

(87) Internationale Veröffentlichungsnummer:
**WO 2007/077065 (12.07.2007 Gazette 2007/28)**

(54) **NANO-THERMOELEKTRIKA**

THERMOELECTRIC NANOMATERIALS

COMPOSANTS NANO-THERMOELECTRIQUES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **29.12.2005 DE 102005063038**

(43) Veröffentlichungstag der Anmeldung:
**17.09.2008 Patentblatt 2008/38**

(73) Patentinhaber: **BASF SE**
**67056 Ludwigshafen (DE)**

(72) Erfinder:
• **KUEHLING, Klaus**
**67158 Ellerstadt (DE)**
• **GRAESER, Martin**
**36093 Künzell (DE)**
• **WENDORFF, Joachim H.**
**35043 Marburg (DE)**
• **GREINER, Andreas**
**35287 Amöneburg (DE)**

(74) Vertreter: **Isenbruck, Günter et al**
**Isenbruck Bösl Hörschler Wichmann Huhn LLP**
**Patentanwälte**
**Theodor-Heuss-Anlage 12**
**68165 Mannheim (DE)**

(56) Entgegenhaltungen:
**EP-A1- 1 283 283          DE-A1- 10 023 456**
**US-A1- 2002 170 590      US-A1- 2003 168 756**

• **D. LI, Y. WANG, Y. XIA: NANO LETTERS, Bd. 3, Nr. 8, 7. August 2003 (2003-08-07), Seiten 1167-1171, XP002430620**
• **DAN LI & YOUNAN XIA: ADV. MATER., Bd. 16, Nr. 14, 19. Juli 2004 (2004-07-19), Seiten 1151-1170, XP002430621**

**Beschreibung**

Die vorliegende Erfindung betrifft Verfahren zur Herstellung von Nanodrähten oder Nanoröhren durch Elektrospinnen von Schmelzen oder Lösungen geeigneter Trägermaterialien, welche gegebenenfalls thermoelektrische Materialien enthalten, Nanodrähte und Nanoröhren, sowie die Verwendung dieser Nanodrähte und Nanoröhren zur thermoelektrischen Temperierung, zur Stromerzeugung, in Sensoren oder zur Temperatursteuerung.

Im Bereich der thermoelektrischen Energieumwandlung ist die Suche nach neuen thermoelektrisch aktiven Materialien mit höherem Wirkungsgrad von großer Bedeutung. Die Eigenschaften thermoelektrischer Materialien werden im so genannten *figure of merit Z*, meist als dimensionslose Größe ZT ausgedrückt, zusammengefasst. Diese Größe ZT gilt es zu maximieren, um einen möglichst hohen Wirkungsgrad zu erzielen.

$$ZT = S^2 \sigma T / \lambda$$

S: Seebeck-Koeffizient, $\mu$V/K
$\sigma$: elektrische Leitfähigkeit, S/cm
T: Temperatur in K
$\lambda$: Wärmeleitfähigkeit, W/(m K)

Seit der Entdeckung von $Bi_2Te_3$ als besonders günstigem Material für Kühlanwendungen vor über 50 Jahren stagniert der maximal erreichte ZT-Wert bei etwa 1. Ab einem ZT-Wert von > 2 könnten thermoelektrische Systeme mit konventionellen Techniken beispielsweise zur Klimatisierung konkurrieren. Die Einsatzbereiche und Anwendungsfelder für Thermoelektrik hängen direkt von der Größe ZT ab.

Bei nanostrukturierten Materialien treten Quanteneffekte auf, die eine Trennung der Elektronen- und Phononenstreuung und somit eine Reduzierung der Wärmeleitfähigkeit bei weitgehendem Erhalt der elektrischen Leitfähigkeit ermöglichen. So gilt in diesem Bereich die klassische Beziehung beruhend auf Wiedemann-Franz, nach der die elektrische Leitfähigkeit direkt proportional der Wärmeleitfähigkeit ist, nur noch eingeschränkt:

$$\lambda / \sigma = aT$$

$\sigma$: elektrische Leitfähigkeit, S/cm
T: Temperatur, K
$\lambda$: Wärmeleitfähigkeit, W/(m K)
a: Proportionalitätsfaktor

In theoretischen Betrachtungen wird für eindimensionale Strukturen, beispielsweise aus Bismut, den so genannten Nanodrähten, ein ZT-Wert von bis ZT = 6 diskutiert. Dabei handelt es sich um Drähte mit einem Durchmesser von ca. 10 nm.

Experimentelle Arbeiten in diesem Größenbereich sind naturgemäß sehr schwierig. Es sind wenige Verfahren zur Herstellung von Nanodrähten bekannt.

In Physical Review Letters, Volume 88, Nr. 21, Seiten 216801-1 bis 216801-4 wird ein Verfahren zur Herstellung von Bismut-Nanodrähten offenbart. Dazu wird geschmolzenes Bismut unter hohem Druck in die Poren entsprechender Template aus $Al_2O_3$ oder Silicagel eingebracht. Die Dicke der Bismut-Drähte, die durch dieses Verfahren hergestellt werden können, ist verfahrensbedingt auf größer als 40 bis 50 nm beschränkt. Des Weiteren wird ein Verfahren zur Herstellung von Nanodrähten mit einem Durchmesser von 7 nm durch Dampfabscheidung auf entsprechenden Formen aus Silicagel offenbart. Auch in diesem Verfahren ist die Länge der Drähte beschränkt.

Thermoelectric Material 2003, Research and Applications, Seiten 3 bis 14 offenbart ein Verfahren zur Herstellung von Nanodrähten mit Durchmessern von 4 bis 200 nm. Diese Drähte werden hergestellt, indem in Formen aus elektrisch nichtleitenden Materialien wie $Al_2O_3$ oder $SiO_2$ Metalle wie Bismut, Antimon und Zink abgeschieden werden. Das Abscheiden wird so durchgeführt, dass die Metalle in einer Vakuumkammer verdampft werden, und sich die entsprechenden Metalldämpfe in den röhrenförmigen Kanälen der Formen niederschlagen.

Eur. J. Inorg. Chem., 2003, 3699 bis 3702 offenbart ein Verfahren zur Herstellung von Arrays, in denen eine Anzahl von Bismut-Nanoröhren parallel angeordnet ist. Dazu wird eine wässrige Lösung von $BiCl_3$ mit Zinkpulver reduziert. Nach Entfernen des überschüssigen Zinkpulvers bleibt ein schwarzes Pulver zurück, in dem Nanoröhren aus Bismut parallel zueinander angeordnet sind.

Eine Übersicht über die bislang bekannten Verfahren zur Herstellung von Nanodrähten gibt Adv. Mater. 2003, 15, No. 5, Seiten 353 - 389. Die offenbarten Verfahren umfassen das Abscheiden von Metallen aus der Dampfphase in entsprechend dimensionierte Formen aus porösem Material, das Einbringen von Lösungen oder Schmelzen entsprechender Verbindungen gegebenenfalls unter hohem Druck in die genannten Formen, oder die Selbstanordnung von Nanopartikeln zu Nanodrähten oder -röhren.

Angew. Chem. 2004, 116, 1356 bis 1367 offenbart ein Verfahren zur Herstellung von Nanoröhren durch Benetzung von entsprechend geformten Templaten mit Lösungen der Materialien, aus denen die Nanoröhren bestehen.

Die genannten Verfahren weisen den Nachteil auf, dass zur Ausrichtung der Nanodrähte die formgebende Matrix erhalten bleiben muss. Es ist daher nicht möglich, durch die bekannten Verfahren freie Nanodrähte in experimentell vorteilhaften Längen zu erhalten. Die Gegenwart der formgebenden Matrix beeinflusst die Wärmeleitfähigkeit negativ. Die absolute erzielbare Länge der Nanodrähte ist kurz, beispielsweise bis 100 $\mu$m. Des Weiteren kann es durch die Abscheidung des Materials aus der Gasphase in extrem enge Kanäle zu Verstopfungen der Kanäle kommen, so dass die gebildeten Nanodrähte nicht durchgängig sind. Die Kontaktierung zu Versuchs- oder Anwendungszwecken der kurzen und in die Matrix eingebetteten Nanodrähte ist schwierig. Daher ist die Kontrolle über die Anzahl der wirklich kontaktierten Drähte und die damit erzielten Messergebnisse problematisch.

Polymerfasern mit einem Durchmesser im Nanometerbereich können durch das Elektrospinn-Verfahren erzeugt werden.

Adv. Mater. 2004, 16, Nr. 14, Seiten 1151 - 1169 offenbart ein Verfahren zur Herstellung von Nanofasern durch Elektrospinnen einer großen Vielzahl von geeigneten Materialien, wie beispielsweise verschiedene Polymere und Copolymere, $Al_2O_3$, $CuO$, $NiO$, $TiO_2$-$SiO_2$, $V_2O_5$, $ZnO$, $Co_3O_4$, $Nb_2O_5$, $MoO_3$ und $MgTiO_3$. Dazu wird eine Schmelze oder Lösung des entsprechenden Materials durch eine feine elektrisch geladene Düse, beispielsweise die Spitze einer Spritze, in Richtung einer gegenteilig geladenen bzw. geerdeten Platte gespritzt. Durch die elektrostatische Anziehung der geladenen Schmelze oder Lösung wird der Strahl so stark beschleunigt, dass er sich auf einen Durchmesser im Nanobereich verjüngt. Bis der Materialstrahl auf den Gegenpol auftrifft, ist enthaltenes Lösungsmittel verdampft bzw. die Schmelze ist soweit abgekühlt, dass sie sich wieder verfestigt hat. Somit kann ein theoretisch endloser Faden mit einem Durchmesser im Nanobereich erhalten werden.

DE 101 16 232 A1 offenbart ein Verfahren zur Herstellung von innenbeschichteten Hohlfasern mit einem Innendurchmesser der Hohlräume bzw. der Hohlfasern mit einem Innendurchmesser von bis zu 100 bis 500 nm. Die Länge der nach diesem Verfahren hergestellten Fasern beträgt 50 $\mu$m bis zu mehreren mm oder cm. Aus einer Lösung oder Schmelze eines ersten Materials ausgewählt aus abbaubaren anorganischen oder organischen Materialien, insbesondere Polymeren, in Mischung mit einem zweiten Material ausgewählt aus katalytisch aktiven Materialien aus den Gruppen Ia, Ib, IIa, IIb, IIIa, IIIb, IVa, IVb; Vb, Vlb, Vllb, und/oder VIIIb des Periodensystems der Elemente im Elektrospinn-Verfahren wird eine Faser mit einem Durchmesser im Nanometer-Bereich erzeugt. Diese Faser wird mit einem dritten nicht abbaubaren Material beschichtet. Nach Entfernen des ersten, abbaubaren Materials durch geeignete Verfahren wird eine Hohlfaser aus dem dritten, nicht abbaubaren Material erhalten, welche an der Innenseite mit dem zweiten, katalytisch aktiven Material beschichtet ist.

Aufgabe der vorliegenden Erfindung ist, ein Verfahren bereitzustellen, durch welches Nanodrähte und Nanoröhren hergestellt werden können, die wenigstens ein thermoelektrisch aktives Material enthalten und die eine ausreichende Länge aufweisen, so dass die oben genannten Nachteile bezüglich der Handhabbarkeit und Kontaktierung vermieden werden können. Eine weitere Aufgabe der vorliegenden Erfindung ist es, ein einfaches und kostengünstiges Verfahren bereitzustellen, durch das Nanodrähte und Nanoröhren, welche wenigstens ein thermoelektrisch aktives Material enthalten, in ausreichender Menge und in gleich bleibender Qualität erzeugt werden.

Die Aufgabe wird gelöst durch ein Verfahren zur Herstellung von Nanodrähten durch Behandlung einer Faser enthaltend wenigstens ein Trägermaterial und wenigstens ein thermoelektrisch aktives Material oder eine Vorläuferverbindung eines thermoelektrisch aktiven Materials, umfassend:

(A) Bereitstellen einer Schmelze oder Lösung, die wenigstens ein Trägermaterial oder geeignete Vorläuferverbindungen des Trägermaterials und wenigstens ein thermoelektrisch aktives Material oder eine Vorläuferverbindung eines thermoelektrisch aktiven Materials enthält,

(B) Elektrospinnen der Schmelze oder Lösung aus Schritt (A), wobei eine Faser enthaltend wenigstens ein Trägermaterial und wenigstens ein thermoelektrisch aktives Material oder eine Vorläuferverbindung eines thermoelektrisch aktiven Materials erhalten wird,

(C) gegebenenfalls Umhüllen der erhaltenen Faser mit einem elektrischen Nichtleiter, wobei eine elektrisch isolierte Faser erhalten wird,

(D) gegebenenfalls Überführen der Vorläuferverbindung des thermoelektrisch aktiven Materials in die aktive Form,

(E) gegebenenfalls Entfernen des Trägermaterials, wobei die Schritte (C) bis (E) in beliebiger Reihenfolge durchgeführt werden können.

Die Aufgabe wird auch gelöst durch ein Verfahren zur Herstellung von Nanoröhren durch Behandlung einer Faser enthaltend wenigstens ein Trägermaterial und wenigstens ein thermoelektrisch aktives Material oder eine Vorläuferverbindung eines thermoelektrisch aktiven Materials, umfassend:

(F) Bereitstellen einer Schmelze oder Lösung, die wenigstens ein Trägermaterial oder geeignete Vorläuferverbindungen des Trägermaterials enthält,

(G) Elektrospinnen der Schmelze oder Lösung aus Schritt (F), wobei eine Faser aus wenigstens einem Trägermaterial erhalten wird,

(H) Umhüllen der in Schritt (G) erhaltenen Faser mit wenigstens einem thermoelektrisch aktiven Material oder einer Vorläuferverbindung eines thermoelektrisch aktiven Materials, wobei eine Faser enthaltend wenigstens ein Trägermaterial und wenigstens ein thermoelektrisch aktives Material oder eine Vorläuferverbindung eines thermoelektrisch aktiven Materials erhalten wird,

(I) gegebenenfalls Umhüllen der erhaltenen Faser mit einem elektrischen Nichtleiter, wobei eine elektrisch isolierte Faser erhalten wird,

(J) gegebenenfalls Überführen der Vorläuferverbindung des thermoelektrisch aktiven Materials in die aktive Form,

(K) gegebenenfalls Entfernen des Trägermaterials, wobei die Schritte (I) bis (K) in beliebiger Reihenfolge durchgeführt werden können.

Das Verfahren zur Herstellung von Nanodrähten und das Verfahren zur Herstellung von Nanoröhren enthalten beide die Behandlung einer Faser enthaltend wenigstens ein Trägermaterial und wenigstens ein thermoelektrisch aktives Material oder eine Vorläuferverbindung eines thermoelektrisch aktiven Materials.

Die einzelnen Schritte werden im Folgenden näher erläutert:

Schritt (A):

Schritt (A) des erfindungsgemäßen Verfahrens zur Herstellung von Nanodrähten umfasst das Bereitstellen einer Schmelze oder Lösung, die wenigstens ein Trägermaterial oder geeignete Vorläuferverbindungen des Trägermaterials und wenigstens ein thermoelektrisch aktives Material oder eine Vorläuferverbindung eines thermoelektrisch aktiven Materials enthält.

In einer bevorzugten Ausführungsform ist das Trägermaterial ein Polymer oder ein Material, das nach dem Sol-Gel-Verfahren erhalten wird. In einer besonders bevorzugten Ausführungsform ist das Trägermaterial ein Polymer. Wird das Trägermaterial nach dem Sol-Gel-Verfahren erhalten, so wird in Schritt (A) eine Lösung geeigneter Vorläuferverbindungen eingesetzt.

Als geeignete Polymere können in dem erfindungsgemäßen Verfahren zur Herstellung von Nanofasern alle bekannten Homopolymere und Copolymere bestehend aus mindestens zwei verschiedenen Monomeren eingesetzt werden, die sich durch das Elektrospinn-Verfahren verspinnen lassen.

Bevorzugt sind dabei Polymere ausgewählt aus der Gruppe bestehend aus Polyestern, Polyamiden, Polyimiden, Polyethern, Polyolefinen, Polycarbonaten, Polyurethanen, natürlichen Polymeren, Polylactiden, Polyglycosiden, Poly-$\alpha$-Methylstyrol, Polymethacrylaten, Polyacrylnitrilen, Latices, Polyalkylenoxiden aus Ethylenoxid und/oder Propylenoxid und Mischungen davon. Besonders bevorzugt ist das Polymer ein Polylactid oder ein Polyamid.

Das erfindungsgemäß einsetzbare Polymer ist nach dem Fachmann bekannten Verfahren herstellbar oder kommerziell erhältlich.

Wird in Schritt (A) des erfindungsgemäßen Verfahrens zur Herstellung von Nanofasern eine Lösung der oben genannten Polymere eingesetzt, so kann diese Lösung alle Lösungsmittel oder Mischungen von Lösungsmitteln enthalten. Diese sind bevorzugt bei einer Temperatur von weniger als 160 °C, besonders bevorzugt weniger als 110 °C bei Normaldruck verdampfbar, und die thermoelektrisch aktiven Materialien oder deren Vorläuferverbindungen sind darin zumindest teilweise löslich.

Im Allgemeinen wird ein Lösungsmittel eingesetzt, ausgewählt aus der Gruppe bestehend aus chlorierten Lösungsmitteln, beispielsweise Dichlormethan oder Chloroform, Aceton, Ether; beispielsweise Diethylether, Methyl-tert.-butyl-ether, Kohlenwasserstoffe mit weniger als 10 Kohlenstoffatomen, beispielsweise n-Pentan, n-Hexan, cyclo-Hexan, Heptan, Oktan, Dimethylsulfoxid (DMSO), N-Methylpyrrolidinon (NMP), Dimethylformamid (DMF), Ameisensäure, Wasser, flüssiges Schwefeldioxid, flüssiger Ammoniak und Mischungen davon. Bevorzugt wird als Lösungsmittel eines ausgewählt aus der Gruppe bestehend aus Dichlormethan, Aceton, Ameisensäure und Mischungen davon eingesetzt.

Das Trägermaterial kann in dem erfindungsgemäßen Verfahren auch nach dem Sol-Gel-Verfahren erhalten werden. Dazu wird in Schritt (A) eine Lösung geeigneter Vorläuferverbindungen des Trägermaterials eingesetzt.

Beim Sol-Gel-Verfahren geht die Herstellung bzw. Abscheidung der Werkstoffe jeweils von einem flüssigen Sol-Zustand aus, der durch eine Sol-Gel-Transformation in einen festen Gel-Zustand überführt wird. Als Sole werden Dispersionen fester Partikel im Größenbereich zwischen 1 nm und 100 nm bezeichnet, die sich feinst verteilt (dispergiert) in Wasser oder organischen Lösungsmitteln befinden. Sol-Gel-Verfahren gehen allgemein von Solsystemen auf der Basis metallorganischer Polymere aus. Der Übergang vom flüssigen Sol zum keramischen Werkstoff erfolgt jeweils über einen Gel-zustand. Während der Sol-Gel-Transformation kommt es zu einer 3-dimensionalen Vernetzung der Nanopartikel im Lösungsmittel, wodurch das Gel Festkörpereigenschaften erhält. Die Überführung des Gels in einen keramischen Werkstoff erfolgt durch eine kontrollierte Behandlung an Luft. Diese Behandlung wird in dem vorliegenden Verfahren während des Spinnens der Faser durchgeführt. Geeignete Sol-Gel-Systeme sind beispielsweise in "Das Sol-Gel-Verfahren, H. K. Schmidt, Chemie in unserer Zeit, 35, 2001, Nr. 3, S. 176 bis 184" genannt.

In Schritt (A) des erfindungsgemäßen Verfahrens zur Herstellung von Nanofasern wird das oben genannte Trägermaterial mit einem thermoelektrisch aktiven Material oder einer Vorläuferverbindung eines thermoelektrisch aktiven Materials gemischt.

Es ist das thermoelektrisch aktive Material wenigstens eine Verbindung enthaltend wenigstens ein Element ausgewählt aus der Gruppe bestehend aus Tellur, Antimon, Silicium, Bor und Germanium und/oder das thermoelektrisch aktive Material ist ausgewählt aus der Gruppe bestehend aus Oxiden, Skutteruditen, Clathraten und Bismut.

Geeignete Oxide sind Cobaltoxide mit Schichtgitter wie $NaCo_2O_4$ oder $Bi_{2-x}Pb_xSr_2Co_2O_y$ mit x = 0 bis 0,6 und y = 8 + σ, aus "Chemistry, Physics and Material Science of Thermoelectric Materials Beyond Bismuth Tellurides", Kluwer Academic/Plenum Publishers, New York 2003, Seiten 71 bis 87. Des Weiteren sind Whisker auf Basis von Cu - Co - O oder Bi - Sr - Co - O geeignet. Darüber hinaus besonders geeignet als thermoelektrisch aktive Materialien auf Basis von Oxiden sind Mischoxide der allgemeinen Formel (I)

$$SrTiO_mS_n \qquad \text{(I)}$$

mit

- $0 \leq n \leq 0,2$ und
- $2 \leq m \leq 2,99$, insbesondere $2 \leq m \leq 2,5$.

Geeignete Oxide sind offenbart in R. Funahashi et al., Jpn. J. Appl. Phys. Vol. 39 (2000), beispielsweise $Ca_2Co_2O_5$, $NaCo_2O_4$ oder $Ca_2Co_4O_9$.

Beispiele für geeignete Telluride sind Telluride auf Basis von Bismut- und Bleitelluriden, beispielsweise $Bi_2Te_3$ oder PbTe Thermoelektrisch aktive Materialien auf Basis von Bismut- oder Bleitelluriden können zusätzlich dotiert werden. Für eine Dotierung geeignet sind Elemente ausgewählt aus der 3. bzw. 5. Hauptgruppe des Periodensystems der Elemente in dem Fachmann bekannten Mengen. Verfahren zur Dotierung der genannten Verbindungen sind dem Fachmann bekannt.

Ein Beispiel für ein geeignetes Antimonid ist $Zn_4Sb_3$ Antimonide werden bevorzugt im mittleren Temperaturbereich, d.h. bei Temperaturen von 100 bis 400 °C eingesetzt.

Beispiele für geeignete Silicide sind $FeSi_2$ und Abwandlungen davon. Silicide werden aufgrund ihrer besonderen Stabilität bevorzugt in Anwendungen aus dem Bereich der Raumfahrt eingesetzt.

Beispiele für geeignete Boride sind $B_4C$ und $CaB_6$ oder $SrB_6$, sowie Abwandlungen davon. Die genannten Boride können auch mit geeigneten Elementen dotiert werden. Für eine Dotierung geeignet sind Elemente ausgewählt aus der 3. bzw. 5. Hauptgruppe des Periodensystems der Elemente in dem Fachmann bekannten Mengen.

Die Boride zeichnen sich durch eine geringe Dichte aus. Sie werden daher bevorzugt in Anwendungen eingesetzt, in denen es auf eine geringe Dichte des thermoelektrisch aktiven Materials ankommt.

Ein Beispiel für geeignete Germanide sind Silicium/Germanium-Legierungen. Diese Legierungen sind besonders für Anwendungen im Hochtemperaturbereich, d.h. Temperaturen oberhalb 500 °C geeignet.

Beispiele für geeignete Skutterudite sind offenbart in Chemistry, Physics and Material Science of Thermoelectric Materials, Kluwer Academic/Plenum Publishers, New York, Seiten 121 - 146, beispielsweise CoSb3, Fe0,5Ni0,5Sb3.

Beispiele für geeignete Clathrate sind in Chemistry, Physics and Material Science of Thermoelectric Materials, Kluwer Academic/Plenum Publishers, New York, Seiten 107 - 121, beispielsweise Typ I: $X_2E_{46}$, z.B. $Sr_8Ga_{16}Ge_{30}$ oder Typ.II: $X_8Y_{16}E_{136}$, z.B. $CS_8Na_{16}Si_{136}$, $Cs_8Na_{16}Ge_{136}$.

In einer bevorzugten Ausführungsform ist das thermoelektrisch aktive Material ausgewählt aus der Gruppe bestehend aus Bismut, $Bi_2Te_3$, PbTe und Mischungen davon.

Die erfindungsgemäß einsetzbaren thermoelektrisch aktiven Materialien sind nach dem Fachmann bekannten Verfahren herstellbar oder kommerziell erhältlich.

Es ist in Schritt (A) des erfindungsgemäßen Verfahrens möglich, die thermoelektrisch aktiven Materialien als solche oder in Form geeigneter Vorläuferverbindungen in die Schmelze oder Lösung einzubringen. Als Vorläuferverbindungen sind alle Verbindungen, Komplexe oder Gemische geeignet, die durch chemische und/oder physikalische Methoden in die thermolelektrisch aktiven Materialien überführt werden können.

In einer bevorzugten Ausführungsform ist die Vorläuferverbindung für das thermoelektrisch aktive Material ein Salz oder ein Komplex des thermoelektrisch aktiven Materials.

In Schritt (A) können das wenigstens eine thermoelektrisch aktive Material oder die Vorläuferverbindung des thermoelektrisch aktiven Materials mit dem wenigstens einen Trägermaterial oder geeignete Vorläuferverbindungen des Trägermaterials in Lösung oder als Schmelze bereitgestellt werden.

Zur Herstellung einer Lösung aus wenigstens einem thermoelektrisch aktiven Material oder einer Vorläuferverbindung des thermoelektrisch aktiven Materials und wenigstens einem Trägermaterial oder geeigneten Vorläuferverbindungen des Trägermaterials, bevorzugt aus wenigstens einem Polymer, können alle dem Fachmann bekannten Verfahren eingesetzt werden. Es kann eine Lösung des wenigstens einen Trägermaterials mit einer Lösung des thermoelektrisch aktiven Materials oder einer Vorläuferverbindung vermischt werden, wobei das gleiche oder verschiedene Lösungsmittel verwendet werden können, die aus der zuvor genannten Gruppe von Lösungsmitteln oder - gemischen ausgewählt sind. Das Mischen kann unter Rühren, unter der Einwirkung von Ultraschall oder unter der Einwirkung von Hitze durchgeführt werden. Geeignete Reaktoren sind dem Fachmann bekannt. Die Konzentration des wenigstens einen Polymers in der Lösung beträgt im Allgemeinen wenigstens 0,1 Gew.-%, bevorzugt 1 bis 30 Gew.-%, besonders bevorzugt 2 bis 20 Gew.-%. Das Verhältnis der Masse der thermolelektrisch aktiven Substanz oder einer Vorläuferverbindung der thermoelektrisch aktiven Substanz zu der Masse des Polymers beträgt im Allgemeinen bis zu 10:1, bevorzugt 1:1 bis 3:1.

Wird in Schritt (A) eine Schmelze eingesetzt, so kann diese nach allen dem Fachmann bekannten Verfahren bereitgestellt werden. Beispielhaft ist hierfür das Erhitzen auf eine Temperatur oberhalb der Schmelztemperatur bzw. der Glastemperatur des Polymers oder der Polymermischung, bevorzugt wenigstens 10 °C, besonders bevorzugt wenigstens 30 °C, ganz besonders bevorzugt wenigstens 50 °C oberhalb der Schmelztemperatur. Das Aufschmelzen wird in einer bevorzugten Ausführungsform im Unterdruck oder in einer Schutzgasatmosphäre durchgeführt, bevorzugt in einer Atmosphäre enthaltend Stickstoff und/oder ein Edelgase, beispielsweise Argon.

Wird als Trägermaterial in Schritt (A) des erfindungsgemäßen Verfahrens ein Polymer eingesetzt, so kann die thermoelektrisch aktive Substanz oder eine Vorläuferverbindung der thermoelektrisch aktiven Substanz kovalent an die Polymerkette gebunden sein. Polymere, welche kovalent gebundene thermoelektrisch aktive Substanzen oder deren Vorläuferverbindungen aufweisen, können durch Polymerisation von Monomeren erhalten werden, an die die Substanzen bereits kovalent gebunden sind. Der Vorteil dieser Vorgehensweise liegt darin, dass die thermoelektrisch aktive Substanz oder ihre Vorläuferverbindung besonders gleichmäßig über das Polymer, und damit die Faser verteilt ist. Geeignete Verfahren sind beispielsweise beschrieben in J. Am. Chem. Soc. 1992, 114, 7295-7296, Chem. Mater. 1992, 4, 24-27 und Chem. Mater. 1992, 4, 894-899.

Schritt (B):

Schritt (B) des erfindungsgemäßen Verfahrens zur Herstellung von Nanodrähten umfasst das Elektrospinnen der Schmelze oder Lösung aus Schritt (A), wobei eine Faser enthaltend wenigstens ein Trägermaterial, bevorzugt wenigstens eine Polymer, und wenigstens ein thermoelektrisch aktives Material oder eine Vorläuferverbindung eines thermoelektrisch aktiven Materials erhalten wird.

Das Verfahren des Elektrospinnens ist dem Fachmann bekannt, beispielsweise aus Adv. Mater. 2004, 16, Nr. 14, Seiten 1151 bis 1169. Dazu wird im Allgemeinen die in Schritt (A) des erfindungsgemäßen Verfahrens bereitgestellte Lösung oder Schmelze durch eine feine Düse, die eine elektrische Ladung aufweist, gepumpt, so dass ein feiner Strahl aus Lösung bzw. Schmelze resultiert. Statt einer Düse können auch andere, dem Fachmann bekannte, Geometrien eingesetzt werden. Die Apparatur zum Spinnen umfasst gegenüber der Düse einen Kollektor, der, bezogen auf die Düse, gegenteilig geladen oder geerdet ist, so dass der durch die Düse aufgeladene Strahl von dem Kollektor angezogen wird. Im Allgemeinen wird eine Spannung von 5 kV bis 100 kV, bevorzugt 10 kV bis 50 kV, angelegt. Ein geeigneter Abstand zwischen der Düse und dem Kollektor ist dem Fachmann bekannt. Durch das resultierende elektrische Feld werden die in dem Lösungs- bzw. Schmelzstrahl befindlichen Teilchen beschleunigt, so dass sich durch diese Beschleunigung der Strahl so stark verjüngt, dass er einen Durchmesser im Nanometer-Bereich aufweist. Der Kollektor ist im Allgemeinen so ausgebildet, dass der Nanodraht, der sich durch Verdampfen des Lösungsmittels oder durch Abkühlen auf eine Temperatur unterhalb der Schmelztemperatur verfestigt hat, durch eine geeignete Methode aufgewickelt oder aufgefangen werden kann.

Wird in Schritt (A) eine Polymerschmelze eingesetzt, so liegt die Temperatur dieser Schmelze vor Austritt aus der Spinndüse wenigstens 10 °C, bevorzugt wenigstens 30 °C, besonders bevorzugt wenigstens 50 °C oberhalb des Schmelzpunktes bzw. $T_G$ des verwendeten Homo-oder Copolymers.

Durch das Elektrospinnen wird eine Faser erhalten, enthaltend wenigstens ein Trägermaterial, bevorzugt wenigstens ein Polymer, und wenigstens ein thermoelektrisch aktives Material oder ein Vorläuferverbindung eines thermoelektrisch aktiven Materials.

An das Elektrospinnen können sich gegebenenfalls Wasch- und Reinigungsschritte anschließen. Im Allgemeinen ist eine Reinigung der erhaltenen Faser nicht notwendig.

Durch das Elektrospinnen der in Schritt (A) bereitgestellten Lösung oder Schmelze enthaltend wenigstens ein Trägermaterial oder geeignete Vorläuferverbindungen des Trägermaterials und wenigstens ein thermoelektrisch aktives Material oder eine Vorläuferverbindung eines thermoelektrisch aktiven Materials in Schritt (B) des erfindungsgemäßen Verfahrens wird eine Faser erhalten, die wenigstens ein Trägermaterial, bevorzugt ein Polymer und wenigstens ein thermoelektrisch aktives Material oder eine Vorläuferverbindung eines thermoelektrisch aktiven Materials enthält.

Die Länge der in Schritt (B) erhaltenen Faser ist grundsätzlich nicht begrenzt. Durch das kontinuierliche Verfahren sind beliebig lange Fasern zugänglich.

In einer bevorzugten Ausführungsform wird die hergestellte Nanofaser auf einer Trommel aufgewickelt. Ist die Trommel auf der gesamten Breite wenigstens einfach von der Nanofaser bedeckt, kann der Spinnvorgang unterbrochen werden, und die Nanofaser kann senkrecht zu der Faser und längs der Trommel durchtrennt werden, so dass eine parallele Anordnung einer Vielzahl von Nanofasern erhalten wird, deren Länge dem Umfang der Trommel entspricht.

In einer weiteren bevorzugten Ausführungsform kann anstelle der Trommel auch ein Metallrahmen verwendet werden, auf den die hergestellten Fasern aufgewickelt werden. Bei dieser Ausführungsform ergibt sich automatisch eine parallele Anordnung der Fasern. Eine solche Vorgehensweise ist beispielsweise in R. Dersch et al., J. Polym. Sci. Part A: Pol. Chem., Vol. 41, 545 - 553, 2003 offenbart.

Die Dicke einer einzelnen in Schritt (B) erhaltenen Faser beträgt weniger als 200 nm, bevorzugt weniger als 50 nm, besonders bevorzugt weniger als 20 nm.

Schritt (C):

Der optionale Schritt (C) des erfindungsgemäßen Verfahrens zur Herstellung von Nanodrähten umfasst das Umhüllen der in Schritt (B) erhaltenen Faser mit einem elektrischen Nichtleiter, wobei eine elektrisch isolierte Faser erhalten wird.

Zur Umhüllung der Nanofaser, die wenigstens ein Trägermaterial, bevorzugt ein Polymer, und wenigstens ein thermoelektrisch aktives Material oder eine Vorläuferverbindung eines thermoelektrisch aktiven Materials enthält, können alle dem Fachmann bekannten Verfahren eingesetzt werden.

Beispielhaft sind Gasphasenabscheidung, Sputtern, Spin-Coating, Dip-Coating, Besprühen oder Plasma-Abscheidung genannt. Bevorzugt wird das Aufbringen eines nichtleitenden Materials durch Tränken oder Besprühen der Nanofaser aus Schritt (B) mit bzw. in einer Lösung des elektrisch nichtleitenden Materials und anschließendem Entfernen des Lösungsmittels, beispielsweise durch Erhitzen, gegebenenfalls unter reduziertem Druck, durchgeführt. Als geeignete Lösungsmittel sind alle Lösungsmittel geeignet, in denen sich das elektrisch nichtleitende Material gut löst, sich aber das wenigstens eine Trägermaterial, welches in Schritt (A) bereitgestellt worden ist, schlecht löst.

In Schritt (C) des erfindungsgemäßen Verfahrens können alle dem Fachmann bekannten elektrischen Nichtleiter eingesetzt werden.

In einer bevorzugten Ausführungsform ist der elektrische Nichtleiter ausgewählt aus aromatischen und aliphatischen Homo- und Copolymeren und Mischungen davon.

Wird als elektrischer Nichtleiter ein Homo- oder Copolymer eingesetzt, so kann dieses Material auch in der Art auf die Nanofaser aus Schritt (B) aufgebracht werden, dass die entsprechenden Monomere in Gegenwart der Faser polymerisiert werden, so dass sich das in situ gebildete Polymer oder Copolymer auf der Faser abscheidet.

Besonders bevorzugt sind die Polymere oder Copolymere ausgewählt aus der Gruppe bestehend aus Poly(p-xylylen), Polyacrylamid, Polyimiden, Polyestern, Polyolefinen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polytetrafluorethen, modifizierte oder nicht modifizierte Cellulose, Alginate oder Collagen, deren Homo- oder Copolymerisate und Mischungen davon.

Die genannten Polymere sind nach dem Fachmann bekannten Verfahren herstellbar oder kommerziell erhältlich.

Besonders bevorzugt ist der elektrische Nichtleiter Poly(p-xylylen) oder Polytetrafluorethen.

Der elektrische Nichtleiter wird bevorzugt durch Gasphasenabscheidung auf die Faser gebracht.

Im Rahmen der vorliegenden Erfindung bedeutet Umhüllen, dass die in Schritt (B) erzeugte Faser zu wenigstens 70%, bevorzugt zu wenigstens 80%, besonders bevorzugt zu wenigstens 90% von einem elektrischen Nichtleiter umschlossen sind. Wird der optionale Schritt (C) des erfindungsgemäßen Verfahrens nicht durchgeführt, wird durch das erfindungsgemäße Verfahren ein Nanodraht erhalten, der an der Außenseite nicht elektrisch isoliert ist.

Schritt (D):

Der optionale Schritt (D) des erfindungsgemäßen Verfahrens umfasst das Überführen der Vorläuferverbindung des thermoelektrisch aktiven Materials in die aktive Form.

Schritt (D) des erfindungsgemäßen Verfahrens muss durchgeführt werden, wenn in Schritt (A) eine Vorläuferverbindung eines thermoelektrisch aktiven Materials in Mischung mit wenigstens einem Polymer eingesetzt wird.

Das Überführen der Vorläuferverbindung in die thermoelektrisch aktive Form kann nach allen dem Fachmann bekannten Methoden erfolgen.

Liegt in einem Komplex das thermoelektrisch aktive Material in der Oxidationsstufe 0 vor, so kann es durch dem Fachmann bekannte Verfahren in freies, nicht komplexiertes thermoelektrisch aktives Material überführt werden. Beispielhaft ist die Umsetzung dieser Komplexe mit anderen Metallen oder Metallkationen, die mit den Komplexliganden des thermoelektrisch aktiven Materials einen stabileren Komplex als den entsprechenden Komplex des thermoelektrisch aktiven Materials bilden.

Werden als Vorläuferverbindungen des thermoelektrisch aktiven Materials Salze oder Komplexe, in denen das thermoelektrisch aktive Material in einer höheren Oxidationsstufe vorliegt, eingesetzt, so können die Vorläuferverbindungen durch Reduktion in das thermoelektrisch aktive Material überführt werden. Die Reduktion kann elektrochemisch oder nasschemisch durchgeführt werden. Geeignete Reduktionsmittel sind Hydride, unedle Metalle wie Zink und Wasserstoff, wobei die Reduktion der Vorläuferverbindungen der thermolelektrisch aktiven Verbindungen mit gasförmigem Wasserstoff eine bevorzugte Ausführungsform des erfindungsgemäßen Verfahrens ist.

In einer besonders bevorzugten Ausführungsform des erfindungsgemäßen Verfahrens zur Herstellung von Nanodrähten wird in Schritt (A) als Vorläuferverbindung der thermoelektrisch aktiven Verbindung ein Salz des Bismuts, besonders bevorzugt Bismuttrichlorid, eingesetzt. Diese Verbindungen des Bismuts können durch Reduktion mit Wasserstoff in das thermoelektrisch aktive Material Bismut überführt werden.

Die Reduktion wird im Allgemeinen nach dem Fachmann bekannten Verfahren durchgeführt werden, bevorzugt wird sie in reinem Wasserstoff bei einer Temperatur von wenigstens 250 °C und einer für wenigstens 20 min durchgeführt.

Schritt (E):

Der optionale Schritt (E) umfasst das Entfernen des Trägermaterials, bevorzugt des Polymers, welches in Schritt (A) eingesetzt wird.

Geeignete Verfahren zum Entfernen des Trägermaterials, bevorzugte des Polymers, sind dem Fachmann bekannt. Beispielhaft sind thermische, chemische, strahleninduzierte, biologische, photochemische Verfahren, sowie Verfahren mittels Plasma, Ultraschall, Hydrolyse oder durch Extraktion mit einem Lösungsmittel genannt. Bevorzugt sind die Lösungsmittelextraktion oder der thermische Abbau. Die Zersetzungsbedingungen liegen je nach Material bei 10 - 500 °C und 0.001 mbar bis 1 bar. Das Entfernen kann vollständig oder zu einem Anteil von wenigstens 70%, bevorzugt wenigstens 80%, besonders bevorzugt wenigstens 90% erfolgen.

Durch das Entfernen des Trägermaterials wird ein Nanodraht erhalten, der ausschließlich oder zu den oben genannten Anteilen thermoelektrisch aktives Material umfasst.

Es ist erfindungsgemäß auch möglich, dass das in Schritt (A) hinzu gegebene Trägermaterial nicht entfernt wird, so dass ein Nanodraht erhalten wird, der neben wenigstens einem thermoelektrisch aktiven Material wenigstens ein Trägermaterial, bevorzugt wenigstens ein Polymer, umfasst.

Die Schritte (C), (D) und (E) sind optional, d.h. es können von den drei Schritten keiner, einer, zwei oder drei Schritte durchgeführt werden.

Des Weiteren ist die Reihenfolge der Schritte (C), (D) und (E) beliebig. Das bedeutet, dass beispielsweise in Anschluss an Schritt (B), Schritt (C), (D) und/oder (E) durchgeführt werden können.

Die unterschiedliche Reihenfolge der Schritte (C), (D) und (E) kann darin begründet sein, dass verschiedene Trägermaterialien und/oder thermoelektrisch aktive Materialien verschiedene Reihenfolgen der genannten Verfahrensschritte bedingen. So kann es beispielsweise sinnvoll sein, dass die Trägermaterialentfernung gemäß Schritt (E) vor der Umhüllung der in Schritt (B) erhaltenen Faser mit einem elektrischen Nichtleiter (Schritt (C)) durchgeführt wird. Des Weiteren ist es möglich, dass das Überführen der Vorläuferverbindung des thermoelektrisch aktiven Materials (Schritt (D)) nach dem Entfernen des Trägermaterials (Schritt (E)) durchgeführt wird. In einer bevorzugten Ausführungsform werden die Schritte des erfindungsgemäßen Verfahrens zur Herstellung von Nanodrähten in der Reihenfolge (A), (B), (C), (D), (E) durchgeführt.

Die vorliegende Erfindung betrifft auch ein Verfahren zur Herstellung von Nanoröhren durch Behandlung einer Faser enthaltend wenigstens ein Trägermaterial und wenigstens ein thermoelektrisch aktives Material oder eine Vorläuferverbindung eines thermoelektrisch aktiven Materials, umfassend:

(F) Bereitstellen einer Schmelze oder Lösung, die wenigstens ein Trägermaterial oder geeignete Vorläuferverbindungen des Trägermaterials enthält,

(G) Elektrospinnen der Schmelze oder Lösung aus Schritt (F), wobei eine Faser aus wenigstens einem Trägermaterial erhalten wird,

(H) Umhüllen der in Schritt (G) erhaltenen Faser mit wenigstens einem thermoelektrisch aktiven Material oder einem Vorläufer eines thermoelektrisch aktiven Materials, wobei eine Faser enthaltend wenigstens ein Trägermaterial und wenigstens ein thermoelektrisch aktives Material oder eine Vorläuferverbindung eines thermoelektrisch aktiven Materials erhalten wird,

(I) gegebenenfalls Umhüllen der erhaltenen Faser mit einem elektrischen Nichtleiter, wobei eine elektrisch isolierte Faser erhalten wird,

(J) gegebenenfalls Überführen der Vorläuferverbindung des thermoelektrisch aktiven Materials in die aktive Form,

(K) gegebenenfalls Entfernen des Trägermaterials, wobei die Schritte (I) bis (K) in beliebiger Reihenfolge durchgeführt werden können.

Die Schritte (F) bis (K) des erfindungsgemäßen Verfahrens zur Herstellung von Nanoröhren werden im Folgenden näher erläutert:

Schritt (F):

Schritt (F) des erfindungsgemäßen Verfahrens zur Herstellung von Nanoröhren umfasst das Bereitstellen einer Schmelze oder Lösung, die wenigstens ein Trägermaterial oder geeignete Vorläuferverbindungen des Trägermaterials enthält.

In einer bevorzugten Ausführungsform ist das Trägermaterial ein Polymer oder ein Material, das aus nach dem Sol-Gel-Verfahren erhalten wird. In einer besonders bevorzugten Ausführungsform ist das Trägermaterial ein Polymer. Wird das Trägermaterial nach dem Sol-Gel-Verfahren erhalten, so wird in Schritt (F) eine Lösung geeigneter Vorläuferverbindungen eingesetzt.

In Schritt (F) des erfindungsgemäßen Verfahrens zur Herstellung von Nanoröhren können die gleichen Trägermaterialien, bevorzugt Polymere, und Lösungsmittel wie in Schritt (A) des erfindungsgemäßen Verfahrens zur Herstellung von Nanodrähten eingesetzt werden. Besonders bevorzugt werden Homo- und Copolymere eingesetzt. Ganz besonders bevorzugt ist das Polymer ein Polylactid oder ein Polyamid.

Die Lösung bzw. die Schmelze, welche wenigstens ein Trägermaterial oder geeignete Vorläuferverbindungen des Trägermaterials enthält, kann durch alle dem Fachmann bekannten Verfahren hergestellt werden.

Für die Herstellung einer Lösung sowie für die Herstellung einer Schmelze enthaltend wenigsten ein Trägermaterial gilt das bezüglich Schritt (A) des erfindungsgemäßen Verfahrens zur Herstellung von Nanodrähten Gesagte. Wird ein Polymer eingesetzt, so beträgt die Konzentration des wenigstens einen Polymers in der Lösung im Allgemeinen wenigstens 0,1 Gew.-%, bevorzugt 1 bis 30 Gew.-%, besonders bevorzugt 2 bis 20 Gew.-%

Schritt (G):

Schritt (G) des erfindungsgemäßen Verfahrens zur Herstellung von Nanoröhren umfasst das Elektrospinnen der Schmelze oder Lösung aus Schritt (F), wobei eine Faser aus wenigstens einem Trägermaterial erhalten wird.

Das Verfahren des Elektrospinnens ist dem Fachmann bekannt, beispielsweise aus Adv. Mate. 2004, 16, Nr. 14, Seiten 1151 - 1169.

Bezüglich des Elektrospinnens gilt das bereits zu Schritt (B) des erfindunsgemäßen Verfahrens zur Herstellung von Nanodrähten Gesagte, mit dem Unterschied, dass in Schritt (G) eine Faser enthaltend wenigstens ein Trägermaterial gesponnen wird.

An das Elektrospinnen in Schritt (G) können sich gegebenenfalls Wasch- und Reinigungsschritte anschließen. Im Allgemeinen ist eine Reinigung der erhaltenen Faser nicht notwendig.

Die Länge der in Schritt (G) erhaltenen Faser ist grundsätzlich nicht begrenzt. Durch das kontinuierliche Verfahren sind beliebig lange Fasern zugänglich.

In einer bevorzugten Ausführungsform wird die hergestellte Nanofaser auf einer Trommel aufgewickelt. Ist die Trommel auf der gesamten Breite wenigstens einfach von der Nanofaser bedeckt, kann der Spinnvorgang unterbrochen werden, und die Nanofaser kann senkrecht zu der Faser und längs der Trommel durchtrennt werden, so dass eine parallele Anordnung einer Vielzahl von Nanofasern erhalten wird, deren Länge dem Umfang der Trommel entspricht.

In einer weiteren bevorzugten Ausführungsform kann anstelle der Trommel auch ein Metallrahmen verwendet werden, auf den die hergestellten Fasern aufgewickelt werden. Bei dieser Ausführungsform ergibt sich automatisch eine parallele Anordnung der Fasern. Eine solche Vorgehensweise ist beispielsweise in R. Dersch et al., J. Polym. Sci. Part A: Pol. Chem., Vol. 41, 545 - 553, 2003 offenbart.

Die Dicke einer einzelnen in Schritt (G) erhaltenen Faser beträgt weniger als 200 nm, bevorzugt weniger als 50 nm, besonders bevorzugt weniger als 20 nm.

Schritt (H):

Schritt (H) des erfindungsgemäßen Verfahrens zur Herstellung von Nanoröhren umfasst das Umhüllen der in Schritt (G) erhaltenen Faser mit wenigstens einem thermoelektrisch aktiven Material oder einem Vorläufer eines thermoelektrisch aktiven Materials, wobei eine Faser enthaltend wenigstens ein Trägermaterial und wenigstens ein thermoelektrisch aktives Material oder eine Vorläuferverbindung eines thermoelektrisch aktiven Materials erhalten wird.

Die Umhüllung der in Schritt (G) erhaltenen Faser mit wenigstens einem thermoelektrisch aktiven Material oder einem Vorläufer eines thermoelektrisch aktiven Materials kann nach allen dem Fachmann bekannten Verfahren durchgeführt werden.

Die Umhüllung der in Schritt (G) erhaltenen Faser kann beispielsweise durch Gasphasenabscheidung, Sputtern, Spin-Coating, Dip-Coating, Besprühen oder Plasmaabscheidung erfolgen. Bevorzugt erfolgt die Umhüllung durch Gasphasenabscheidung.

Bezüglich geeigneter thermoelektrisch aktiver Materialien oder Vorläuferverbindungen thermoelektrisch aktiver Materialien gilt das zu Schritt (A) des erfindungsgemäßen Verfahrens zur Herstellung von Nanodrähten Gesagte.

Besonders bevorzugt wird in dem verfahren zur Herstellung von Nanoröhren als thermoelektrisch aktives Material Bismut eingesetzt.

Im Rahmen der vorliegenden Erfindung bedeutet Umhüllen, dass die in Schritt (H) erzeugte Faser zu wenigstens 50%, bevorzugt zu wenigstens 80%, besonders bevorzugt zu wenigstens 90% von wenigstens einem thermoelektrisch aktiven Material oder von einer Vorläuferverbindung des thermoelektrischen Materials umschlossen ist. Schritt (H) des erfindungsgemäßen Verfahrens zur Herstellung von Nanoröhren kann im Allgemeinen auch Wasch- und Reinigungsschritte der umhüllten Faser umfassen. In einer bevorzugten Ausführungsform werden keine Wasch- und Reinigungsschritte durchgeführt.

Die Dicke der in Schritt (H) auf die Faser aufgebrachten Schicht aus wenigstens einem thermoelektrisch aktiven Material oder einer Vorläuferverbindung eines thermoelektrisch aktiven Materials beträgt im Allgemeinen 1 nm bis 100 nm, bevorzugt 5 nm bis 30 nm.

In Schritt (H) des erfindungsgemäßen Verfahrens zur Herstellung von Nanoröhren wird eine Faser erhalten, die wenigstens ein Trägermaterial enthält, und die von einer Schicht eines thermoelektrisch aktiven Materials oder einer Vorläuferverbindung des thermoelektrisch aktiven Materials umhüllt ist.

Schritt (I):

Der optionale Schritt (I) des erfindungsgemäßen Verfahrens zur Herstellung von Nanoröhren umfasst das Umhüllen der erhaltenen Faser mit einem elektrischen Nichtleiter, wobei eine elektrisch isolierte Faser erhalten wird.

Bezüglich des Umhüllens mit einem elektrischen Nichtleiter gilt das bereits zu Schritt (C) des erfindungsgemäßen Verfahrens zur Herstellung von Nanodrähten Gesagte.

Zur Umhüllung der in Schritt (H) erhaltenen Nanofaser, die wenigstens ein Trägermaterial, bevorzugt wenigstens ein Polymer, und wenigstens ein thermoelektrisch aktives Material oder eine Vorläuferverbindung eines thermoelektrisch aktiven Materials enthält, wobei das thermoelektrisch aktive Material oder eine Vorläuferverbindung als eine äußere Schicht eine Nanofaser aus wenigstens einem Polymer umhüllt, können alle dem Fachmann bekannten Verfahren eingesetzt werden.

Bevorzugt wird der elektrische Nichtleiter durch Gasphasenabscheidung auf die Faser aufgebracht.

Besonders bevorzugt wird Poly(p-xylylen) oder Polytetrafluorethen als elektrischer Nichtleiter eingesetzt.

Wird der optionale Schritt (I) nicht durchgeführt, wird durch das erfindungsgemäße Verfahren ein Nanoröhren erhalten, welches an der Außenseite nicht elektrisch isoliert ist.

Schritt (J):

Der optionale Schritt (J) des erfindungsgemäßen Verfahrens zur Herstellung von Nanoröhren umfasst das Überführen der Vorläuferverbindung des thermoelektrisch aktiven Materials in die aktive Form.

Bezüglich des Überführens der Vorläuferverbindung des thermoelektrisch aktiven Materials in das thermoelektrisch aktive Material gilt das bereits zu Schritt (D) des erfindungsgemäßen Verfahrens zur Herstellung von Nanodrähten Gesagte.

Der optionale Schritt (J) muss nur dann durchgeführt werden, wenn in Schritt (H) eine Vorläuferverbindung der thermoelektrisch aktiven Verbindung auf die Faser aus Schritt (G) aufgebracht wird. Wird in Schritt (H) das thermoelektrisch aktive Material auf die Faser aufgebracht, kann Schritt (J) entfallen.

Wird in Schritt (H) ein Salz des thermoelektrisch aktiven Materials auf die Faser aufgebracht, wird in dieser Ausführungsform Schritt (J) durchgeführt

Schritt (K):

Der optionale Schritt (K) des erfindungsgemäßen Verfahrens zur Herstellung von Nanoröhren umfasst das Entfernen des Trägermaterials, bevorzugt des Polymers. Wird Schritt (K) nicht durchgeführt, so werden durch das erfindungsgemäße Verfahren Nanoröhren erhalten, die mit Trägermaterial gefüllt sind.

Bezüglich des Entfernens des Trägermaterials in Schritt (K) des erfindungsgemäßen Verfahrens zur Herstellung von Nanoröhren gilt das bereits zu Schritt (E) des erfindungsgemäßen Verfahrens zur Herstellung von Nanodrähten Gesagte.

Im Allgemeinen wird das Trägermaterial, bevorzugt das Polymer, in Schritt (K) zu wenigstens 30%, bevorzugt zu wenigstens 50%, besonders bevorzugt zu wenigstens 70% entfernt.

In einer bevorzugten Ausführungsform wird das Trägermaterial durch Lösungsmittelextraktion entfernt. Im Allgemeinen können dazu alle Lösungsmittel und Lösungsmittelgemische verwendet werden, die das Trägermaterial, welches in Schritt (F) eingesetzt worden ist, gut lösen, aber den elektrischen Nichtleiter, der gegebenenfalls in Schritt (I) aufgebracht wird, schlecht lösen.

Die Nanoröhre weist einen Durchmesser von weniger als 200 nm, bevorzugt weniger als 50 nm, besonders bevorzugt 20 nm, einer Wandstärke von weniger als 20 nm, bevorzugt weniger als 10 nm und einer Länge von wenigstens 1 mm, bevorzugt wenigstens 10 mm, besonders bevorzugt wenigstens 100 mm auf. Die Länge des Röhrchens ist aufgrund des kontinuierlichen Verfahrens nicht begrenzt.

Die Schritte (I), (J) und (K) können in beliebiger Reihenfolge durchgeführt werden. In einer bevorzugten Ausführungsform werden die Schritte (I), (J) und (K) in der Reihenfolge (I), (J), (K) durchgeführt.

Die vorliegende Erfindung betrifft auch einen Nanodraht, enthaltend wenigstens ein thermoelektrisch aktives Material, mit einem Durchmesser von weniger als 200 nm, bevorzugt weniger als 50 nm, besonders bevorzugt weniger als 20 nm, und einer Länge von wenigstens 1 mm, bevorzugt wenigstens 10 mm, besonders bevorzugt wenigstens 100 mm.

Die vorliegende Erfindung betrifft auch Nanoröhren, enthaltend wenigstens ein thermoelektrisch aktives Material mit einem Durchmesser von weniger als 200 nm, bevorzugt weniger als 50 nm, besonders bevorzugt 20 nm, einer Wandstärke von weniger als 20 nm, bevorzugt weniger als 10 nm und einer Länge von wenigstens 1 mm, bevorzugt wenigstens 10 mm, besonders bevorzugt wenigstens 100 mm.

Die vorliegende Erfindung betrifft auch die Verwendung der erfindungsgemäßen Nanodrähte oder Nanoröhren zur thermoelektrischen Temperierung, zur Stromerzeugung, in Sensoren, in der Telekommunikation oder zur Temperatursteuerung.

Beispiele für Sensoren sind CCD-Arrays, Gassensoren, Sensoren auf Halbleiterbausteinen oder auf CPUs.

Beispiele für thermoelektrische Temperierung sind Heizungen, Zusatzheizungen, Klimaanlagen.

Vorteilhaft bei der Temperatursteuerung mit Hilfe der erfindungsgemäßen Nanodrähten und/oder Nanoröhren ist, dass diese eine sehr genaue Temperatursteuerung ermöglichen. Des Weiteren regiert eine solche Temperatursteuerung sehr schnell und präzise.

Beispiele für die Verwendung bei der Stromerzeugung sind das Erhitzen durch Verbrennen von fossilen Brennstoffen wie Kohle, Erdöl, Erdgas oder Holz, durch katalytische Verbrennung, durch Abwärme oder durch die Sonne. Dabei wird durch das Erhitzen der erfindungsgemäßen Nanodrähte oder Nanoröhren auf die oben genannten Arten mittels der thermoelektrisch aktiven Materialien in den Nanodrähten oder Nanoröhren ein elektrischer Strom erzeugt.

Das Vermessen der erfindungsgemäßen Nanodrähte oder Nanoröhren zu Versuchs- oder Anwendungszwecken kann nach allen dem Fachmann bekannten Verfahren und Methoden durchgeführt werden.

Beispiele:

Beispiel 1:

Herstellung von Nanoröhren:

Als Templat für die Bismutröhrchen dienen elektrogesponnene PA66 Fasern:

Fasergewinnung:

Versponnen wird eine Lösung von m/m15% PA66 in Ameisensäure (p.a. 98-100%). Das Spinnen erfolgt aus einer PE Spritze mit Metallkanüle (0,6 mm ⌀) auf eine rotierende Aluminiumwalze mit einem Durchmesser von 155 mm, die mit einer Geschwindigkeit von 3500 U/min rotiert. Die angelegte Spannung beträgt +22 kV an der Spritzenkanüle gegen -2 kV an der Walze (jeweils gegen Erde) bei einem Kanülen/Walzen Abstand von ca. 60 mm (Elektrische Feldstärke E = 400 kV/m). Der Vortrieb für die Spritze wird entsprechend angepasst, dass kontinuierlich Lösung an der Kanülenspitze zur Verfügung steht.

Zur besseren Gewinnung der Fasern wird auf die Walze entweder Aluminiumfolie oder PE Folie aufgebracht, auf der sich die Fasern abscheiden. Um ein gutes Ablösen der Fasern von der Folie zu gewährleisten, müssen mehrere Lagen von Fäden abgeschieden werden. Dies erfordert mindestens eine Spinndauer von 15 bis 30 min. Die aufgebrachte Folie mit Fasern wird quer zur Walze aufgeschnitten. Die erzeugten Fasern haben somit eine Länge von ca. 487 mm.

Aufdampfen der Bismutschicht:

Die Fasern werden in einer dünnen Schicht von der Folie abgezogen und in einen Messinghalter von ca. 25 x 25 $mm^2$ eingespannt.

Die Bedampfung erfolgt in einem Widerstandsbedampfer, wobei die Probe ca. 150 mm oberhalb des Molybdän Schiffchens mit der eingeschmolzenen Bismutperle angebracht ist. Der Messinghalter wird während des Bedampfens mit ca. 20 U/min um die Achse entlang der Faserrichtung rotiert, die Bedampfung erfolgt mit Schichtdickenkontrolle über einen Schwingquarz. Um eine gleichmäßige Beschichtung zu erreichen, wird mit sehr geringer Rate von ca. 1-2 nm pro min bedampft.

Beispiel 2:

Herstellung von Nanodrähten durch Einspinnen von Bi-Salzen:

Herstellung von Poly-D,L-Lactid/BiCl$_3$ Nanofasern:

Versponnen wird eine Lösung von m/m 11% PDLLA/16,5% BiCl$_3$ in Aceton. Das Verspinnen erfolgt aus einer PE Spritze mit Metallkanüle (0,45 mm 0) auf eine rotierende Aluminiumwalze (155 mm $\varnothing$, 3500 U/min). Die angelegte Spannung beträgt +13 kV an der Spritzenkanüle gegen -2 kV an der Walze (jeweils gegen Erde) bei einem Kanülen/Walzen Abstand von ca. 60 mm (Elektrische Feldstärke E = 250 kV/m). Der Vortrieb für die Spritze wird entsprechend angepasst, dass kontinuierlich Lösung an der Kanülenspitze zur Verfügung steht.

Zur besseren Gewinnung der Fasern wird auf die Walze PE Folie aufgebracht, auf der sich die Fasern abscheiden. Um ein gutes Ablösen der Fasern von der Folie zu gewährleisten, müssen mehrere Lagen von Fäden abgeschieden werden. Dies erfordert mindestens eine Spinndauer von 10 bis 20 min. Die aufgebrachte Folie mit Fasern wird quer zur Walze aufgeschnitten. Die erzeugten Fasern haben somit eine Länge von ca. 487 mm.

Polyparaxylylen Beschichtung:

Die Beschichtung erfolgt nach dem CVD Verfahren nach Gorham, wobei ein kommerziell erhältliches Gerät der Firma "Speciality Coating Systems" SCS (Labcoate®1, Parylene Deposition Unit Model PDS 2010) eingesetzt wird. Als Ausgangsmaterial dient [2,2]-Paracyclophan. Das Monomer wird bei bis zu 175 °C verdampft und bei 650 °C zu Chinodimethan pyrolysiert. Anschließend erfolgt bei einem Maximaldruck von 55 mbar und weniger als 30 °C die Abscheidung / Polymerisation als Film auf den Fasern.

Zum Beschichten werden die Fasern auf Metallrahmen so aufgewickelt, dass sie nach Möglichkeit von allen Seiten offen zugänglich sind. In dieser Durchführung wurden 500 mg Monomer eingewogen, um ca. 250 nm Schichtdicke zu erhalten.

Polytetrafluorethylen Beschichtung:

Die Beschichtung erfolgt mittels Sputtertechnik. Die Sputterkammer wird evakuiert bis zu einem Druck von $10^{-6}$ mbar und anschließend das Plasma gestartet (der Druck steigt auf ca. $10^{-3}$ mbar). Das Polytetrafluorethylen Target (ca. 50 mm $\varnothing$) befindet sich ca. 50-60 mm entfernt von der Faserprobe. Die Fasern sind in einen Messinghalter von ca. 25 x 25 $mm^2$ eingespannt und rotieren mit 15 U/min um die Achse entlang der Faserrichtung. Die Abscheidung erfolgt mit einer Rate von ca. 5 nm/min (gemessen mit Schwingquarz).

Reduktion zu metallischem Bismut:

Die Reduktion erfolgt in einem Röhrenofen, der mittels Steuergerät Temperaturrampen fahren kann. Das Programm sieht drei Segmente vor: Aufheizen (in 30 min auf 260°C), Tempern (20 min bei 260°C), Abkühlen (ca. 30 min auf RT), das Abkühlen erfolgt langsamer als die Ofensteuerung vorsieht und hängt von den Umgebungsbedingungen ab. Vor dem Start der Reduktion wird die Probe im Röhrenofen evakuiert (ca. 0,1 mbar) und anschließend mit Wasserstoff geflutet, während der Dauer der Reduktion wird kontinuierlich ein geringer Wasserstoffstrom über die Probe geleitet (ca. 5 mL/min).

Reduktion zu metallischem Bismut mit anschließendem Entfernen der PDLLA Kernfaser:

Hierfür sind 5 Segmente vorgesehen: Aufheizen (30 min bis auf 260°C), Tempern (20 min bei 260°C), Aufheizen (10 min auf 270°C), Tempern (5 h bei 270°C), Abkühlen (30 min auf RT), das Abkühlen erfolgt langsamer als die Ofensteuerung vorsieht und hängt von den Umgebungsbedingungen ab.

Vor dem Start der Reduktion wird die Probe im Röhrenofen evakuiert (ca. 0,1 mbar) und anschließend mit Wasserstoff geflutet, während der Dauer der Reduktion wird kontinuierlich ein geringer Wasserstoffstrom über die Probe geleitet (ca. 5 mL/min).

Während des Aufheizens auf 270°C wird auf Schutzgas (Argon) umgeschaltet /gespült und anschließend evakuiert, so dass während des anschließenden Tempervorgangs ein Druck von ca. ≤ 0,5 mbar anliegt.

Beispiel 3:

Herstellung von Nanodrähten durch Einspinnen von Bi-Partikeln:

Herstellung von Bi-Nanopartikeln:

Die Herstellung erfolgt unter Argonatmosphäre.

In einem Schlenkgefäß werden 25 mmol Natriumhydrid NaH vorgelegt, entgast und zweimal mit absolutem Tetrahydrofuran THF gewaschen, anschließend 20 mL THF zugesetzt und auf 65 °C erwärmt. Es werden 10 mmol *tert*-Butanol in 5 mL THF zugegeben und die Suspension einige Zeit gerührt. Unter starkem Rühren werden (auf einmal) 5 mmol feinpulvriges $BiCl_3$ zugegeben und die Lösung für eine halbe Stunde bei 65 °C gehalten. Direkt nach Zugabe beginnt sich die Lösung nach schwarz umzufärben. Anschließend wird die Lösung auf RT abgekühlt und 20 mL absolutes THF zugesetzt, über Nacht rühren gelassen und einrotiert. Es bleibt ein schwarzes Pulver zurück, das unter dem Elektronenmikroskop ca. 5 nm große Partikel aufweist.

Herstellung von Poly-D,L-Lactid/Bi Nanofasern:

Versponnen wird eine Lösung von m/m 4% PDLLA/4% Bi Partikel in Dichlormethan. Das Verspinnen erfolgt aus einer PE Spritze mit Metallkanüle (0,45 mm ∅) auf eine rotierende Aluminiumwalze (155 mm ∅, 3500 U/min). Die angelegte Spannung beträgt +13 kV an der Spritzenkanüle gegen -2 kV an der Walze (jeweils gegen Erde) bei einem Kanülen/Walzen Abstand von ca. 60 mm (Elektrische Feldstärke E = 250 kV/m). Der Vortrieb für die Spritze wird entsprechend angepasst, dass kontinuierlich Lösung an der Kanülenspitze zur Verfügung steht.

Zur besseren Gewinnung der Fasern wird auf die Walze PE Folie aufgebracht, auf der sich die Fasern abscheiden. Um ein gutes Ablösen der Fasern von der Folie zu gewährleisten, müssen mehrere Lagen von Fäden abgeschieden werden. Dies erfordert mindestens eine Spinndauer von 10 bis 20 min. Die aufgebrachte Folie mit Fasern wird quer zur Walze aufgeschnitten. Die erzeugten Fasern haben somit eine Länge von ca. 487 mm.

Entfernen der PDLLA Kernfaser:

Hierfür sind 3 Segmente vorgesehen: Aufheizen (30 min bis auf 270°C), Tempern (5 h bei 270°C), Abkühlen (30 min auf RT), das Abkühlen erfolgt langsamer als die Ofensteuerung vorsieht und hängt von den Umgebungsbedingungen ab.

Der Röhrenofen wird vor dem Start des Programms evakuiert, so dass während des gesamten Programms ein Druck von ca. ≤ 0,5 mbar anliegt.

**Patentansprüche**

1. Verfahren zur Herstellung von Nanodrähten durch Behandlung einer Faser enthaltend wenigstens ein Trägermaterial und wenigstens ein thermoelektrisch aktives Material oder eine Vorläuferverbindung eines thermoelektrisch aktiven Materials, umfassend:

(A) Bereitstellen einer Schmelze oder Lösung, die wenigstens ein Trägermaterial oder geeignete Vorläuferverbindungen des Trägermaterials und wenigstens ein thermoelektrisch aktives Material oder eine Vorläuferverbindung eines thermoelektrisch aktiven Materials enthält,

(B) Elektrospinnen der Schmelze oder Lösung aus Schritt (A), wobei eine Faser enthaltend wenigstens ein Trägermaterial und wenigstens ein thermoelektrisch aktives Material oder eine Vorläuferverbindung eines thermoelektrisch aktiven Materials erhalten wird,

(C) gegebenenfalls Umhüllen der erhaltenen Faser mit einem elektrischen Nichtleiter, wobei eine elektrisch isolierte Faser erhalten wird,

(D) gegebenenfalls Überführen der Vorläuferverbindung des thermoelektrisch aktiven Materials in die aktive Form,

(E) gegebenenfalls Entfernen des Trägermaterials, wobei die Schritte (C) bis (E) in beliebiger Reihenfolge durchgeführt werden können, wobei das thermoelektrisch aktive Material wenigstens eine Verbindung enthaltend wenigstens ein Element ausgewählt aus der Gruppe bestehend aus Tellur und Bor ist, oder das thermoelektrisch aktive Material ist ausgewählt aus der Gruppe bestehend aus Antimoniden, Siliciden, Germaniden, Skutteruditen, Clathraten, Bismut, $NaCO_2O_4$, $Bi_{2-x}Ph_xSr_2CO_xO_y$ mit x = 0 bis 0,6 und y = 8 + σ, Whisker auf Basis von Cu-Co-O oder Bi-Sr-Co-O, Mischoxide der Formel (I)

$$SrTiO_mS_n \qquad (I)$$

mit

$0 \leq n \leq 0,2$ und
$2 \leq m \leq 2, 99$,

$Ca_2CO_2O_5$, $NaCo_2O_4$, $Ca_2Co_4O_9$ und Mischungen davon.

2. Verfahren zur Herstellung von Nanoröhren durch Behandlung einer Faser enthaltend wenigstens ein Trägermaterial und wenigstens ein thermoelektrisch aktives Material oder eine Vorläuferverbindung eines thermoelektrisch aktiven Materials, umfassend:

(F) Bereitstellen einer Schmelze oder Lösung, die wenigstens ein Trägermaterial oder geeignete Vorläuferverbindungen des Trägermaterials enthält,

(G) Elektrospinnen der Schmelze oder Lösung aus Schritt (F), wobei eine Faser aus wenigstens einem Trägermaterial erhalten wird,

(H) Umhüllen der in Schritt (G) erhaltenen Faser mit wenigstens einem thermoelektrisch aktiven Material oder einem Vorläufer eines thermoelektrisch aktiven Materials, wobei eine Faser enthaltend wenigstens ein Trägermaterial und wenigstens ein thermoelektrisch aktives Material oder eine Vorläuferverbindung eines thermoelektrisch aktiven Materials erhalten wird,

(I) gegebenenfalls Umhüllen der erhaltenen Faser mit einem elektrischen Nichtleiter, wobei eine elektrisch isolierte Faser erhalten wird,

(J) gegebenenfalls Überführen der Vorläuferverbindung des thermoelektrisch aktiven Materials in die aktive Form,

(K) gegebenenfalls Entfernen des Trägermaterials, wobei die Schritte (I) bis (K) in beliebiger Reihenfolge durchgeführt werden können, wobei das thermoelektrisch aktive Material wenigstens eine Verbindung ist enthaltend wenigstens ein Element ausgewählt aus der Gruppe bestehend aus Tellur, Antimon, Silicium und Germanium und/oder das thermoelektrisch aktive Material ist ausgewählt aus der Gruppe bestehend aus Cobaltoxiden mit Schichtgitter, Whisker auf Basis von Cu-Co-O oder Bi-Sr-Co-O, Mischoxide der allgemeinen Formel (I)

$$SrTiO_mS_n \qquad (I)$$

mit

$0 \leq n \leq 0,2$ und
$2 \leq m \leq 2,99$,

$Ca_2CO_2O_5$, $NaCo_2O_4$, $Ca_2Co_4O_9$, Boriden, Skutteruditen, Clathraten und Bismut.

3. Verfahren nach Anspruch 1 oder 2, **dadurch gekennzeichnet, dass** das Trägermaterial ein Polymer oder ein Material ist, das nach dem Sol-Gel-Verfahren erhalten wird.

**4.** Verfahren nach Anspruch 3, **dadurch gekennzeichnet, dass** das Polymer ein Polylactid oder ein Polyamid ist.

**5.** Verfahren nach einem der Ansprüche 1 bis 4, **dadurch gekennzeichnet, dass** die Vorläuferverbindung für das thermoelektrisch aktive Material ein Salz oder ein Komplex des thermoelektrisch aktiven Materials ist.

**6.** Verfahren nach einem der Ansprüche 1 bis 5, **dadurch gekennzeichnet, dass** das thermoelektrisch aktive Material ausgewählt ist aus der Gruppe bestehend aus Bismut, $Bi_2Te_3$, PbTe und Mischungen davon.

**7.** Verfahren nach einem der Ansprüche 1 bis 6, **dadurch gekennzeichnet, dass** der elektrische Nichtleiter ausgewählt ist aus der Gruppe bestehend aus aromatischen und aliphatischen Homo- und Copolymeren und Mischungen davon.

**8.** Verfahren nach Anspruch 7, **dadurch gekennzeichnet, dass** der elektrische Nichtleiter Poly-para-xylylen oder Polytetrafluorethen ist.

**9.** Nanodraht, enthaltend wenigstens ein thermoelektrisch aktives Material, mit einem Durchmesser von weniger als 200 nm und einer Länge von wenigstens 10 mm, wobei wobei das thermoelektrisch aktive Material wenigstens eine Verbindung enthaltend wenigstens ein Element ausgewählt aus der Gruppe bestehend aus Tellur und Bor ist, oder das thermoelektrisch aktive Material ist ausgewählt aus der Gruppe bestehend aus Antimoniden, Siliciden, Germaniden, Skutteruditen, Clathraten, Bismut, $NaCO_2O_4$, $Bi_{2-x}Ph_xSr_2Co_2O_y$ mit x = 0 bis 0,6 und y = 8 + σ, Whisker auf Basis von Cu-Co-O oder Bi-Sr-Co-O, Mischoxide der Formel (I)

$$SrTiO_mS_n \qquad (I)$$

mit

$0 \le n \le 0,2$ und
$2 \le m \le 2,99$,
$Ca_2CO_2O_5$, $NaCo_2O_4$, $Ca_2Co_4O_9$ und Mischungen davon

**10.** Nanoröhren, enthaltend wenigstens ein thermoelektrisch aktives Material, mit einem Durchmesser von weniger als 200 nm, einer Wandstärke von weniger als 30 nm und einer Länge von wenigstens 1 mm, wobei wobei das thermoelektrisch aktive Material wenigstens eine Verbindung ist enthaltend wenigstens ein Element ausgewählt aus der Gruppe bestehend aus Tellur, Antimon, Silicium und Germanium und/oder das thermoelektrisch aktive Material ist ausgewählt aus der Gruppe bestehend aus Cobaltoxiden mit Schichtgitter, Whisker auf Basis von Cu-Co-O oder Bi-Sr-Co-O, Mischoxide der allgemeinen Formel (I)

$$SrTiO_mS_n \qquad (I)$$

mit

$0 \le n \le 0,2$ und
$2 \le m \le 2,99$,

$Ca_2CO_2O_5$, $NaCo_2O_4$, $Ca_2Co_4O_9$, Boriden, Skutteruditen, Clathraten und Bismut.

**11.** Verwendung von Nanodrähten gemäß Anspruch 9 oder Nanoröhren gemäß Anspruch 10 zur thermoelektrischen Temperierung, zur Stromerzeugung, in Sensoren oder zur Temperatursteuerung.

**Claims**

**1.** A process for producing nanowires by treating a fiber comprising at least one support material and at least one thermoelectrically active material or a precursor compound of a thermoelectrically active material, comprising:

(A) providing a melt or solution which comprises at least one support material or suitable precursor compounds of the support material and at least one thermoelectrically active material or a precursor compound of a thermoelectrically active material,
(B) electrospinning the melt or solution from step (A) to obtain a fiber comprising at least one support material and at least one thermoelectrically active material or a precursor compound of a thermoelectrically active material,

(C) if appropriate enveloping the fiber obtained with an electrical nonconductor to obtain an electrically insulated fiber,

(D) if appropriate converting the precursor compound of the thermoelectrically active material to the active form,

(E) if appropriate removing the support material, steps (C) to (E) being performable in any sequence, the thermoelectrically active mateial being at least one compound comprising at least one element selected from the group consisting of tellurium and boron, or the thermoelectrically active material being selected from the group consisting of antimonides, silicides, germanides, skutterudites, clathrates, bismuth, $NaCo_2O_4$, $Bi_{2-x}Ph_xSr_2Co_2O_y$ where x = from 0 to 0.6 and y = 8 + σ, whiskers based on Cu-Co-O or Bi-Sr-Co-O, mixed oxides of the formula (I)

$$SrTiO_mS_n \qquad (I)$$

Where

$0 \leq n \leq 0.2$ and
$2 \leq m \leq 2.99$,

$Ca_2CO_2O_5$, $NaCo_2O_4$, $Ca_2Co_4O_9$ and mixtures thereof.

2. A process for producing nanotubes by treating a fiber comprising at least one support material and at least one thermoelectrically active material or a precursor compound of a thermoelectrically active material, comprising:

(F) providing a melt or solution which comprises at least one support material or suitable precursor compounds of the support material,

(G) electrospinning the melt or solution from step (F) to obtain a fiber of at least one support material,

(H) enveloping the fiber obtained in step (G) with at least one thermoelectrically active material or a precursor of a thermoelectrically active material to obtain a fiber comprising at least one support material and at least one thermoelectrically active material or a precursor compound of a thermoelectrically active material,

(I) if appropriate enveloping the fiber obtained with an electrical nonconductor to obtain an electrically insulated fiber,

(J) if appropriate converting the precursor compound of the thermoelectrically active material to the active form,

(K) if appropriate removing the support material, steps (I) to (K) being performable in any sequence, the thermoelectrically active material being at least one compound comprising at least one element selected from the group consisting of tellurium, antimony, silicon and germanium and/or the thermoelectrically active material being selected from the group consisting of cobalt oxides with a layer lattice, whiskers based on Cu-Co-O or Bi-Sr-Co-O, mixed oxides of the general formula (I)

$$SrTiO_mS_n \qquad (I)$$

Where

$0 \leq n \leq 0.2$ and
$2 \leq m \leq 2.99$,

$Ca_2CO_2O_5$, $NaCo_2O_4$, $Ca_2Co_4O_9$, borides, skutterudites, clathrates and bismuth.

3. The process according to claim 1 or 2, wherein the support material is a polymer or a material which is obtained by the sol-gel process.

4. The process according to claim 3, wherein the polymer is a polylactide or a polyamide.

5. The process according to any of claims 1 to 4, wherein the precursor compound for the thermoelectrically active material is a salt or a complex of the thermoelectrically active material.

6. The process according to any of claims 1 to 5, wherein the thermoelectrically active material is selected from the group consisting of bismuth, $Bi_2Te_3$, PbTe and mixtures thereof.

7. The process according to any of claims 1 to 6, wherein the electrical nonconductor is selected from the group consisting of aromatic and aliphatic homo- and copolymers and mixtures thereof.

8. The process according to claim 7, wherein the electrical nonconductor is poly-para-xylylene or polytetrafluoroethene.

9. A nanowire comprising at least one thermoelectrically active material and having a diameter of less than 200 nm and a length of at least 10 mm, the thermoelectrically active mateial being at least one compound comprising at least one element selected from the group consisting of tellurium and boron, or the thermoelectrically active material being selected from the group consisting of antimonides, silicides, germanides, skutterudites, clathrates, bismuth, $NaCo_2O_4$, $Bi_{2-x}Ph_xSr_2Co_2O_y$ where x = from 0 to 0.6 and y = 8 + σ, whiskers based on Cu-Co-O or Bi-Sr-Co-O, mixed oxides of the formula (I)

$$SrTiO_mS_n \qquad (I)$$

Where

$0 \leq n \leq 0.2$ and
$2 \leq m \leq 2.99$,

$Ca_2CO_2O_5$, $NaCo_2O_4$, $Ca_2CO_4O_9$ and mixtures thereof.

10. A nanotube comprising at least one thermoelectrically active material and having a diameter of less than 200 nm, a wall thickness of less than 30 nm and a length of at least 1 mm, the thermoelectrically active material being at least one compound comprising at least one element selected from the group consisting of tellurium, antimony, silicon and germanium and/or the thermoelectrically active material being selected from the group consisting of cobalt oxides with a layer lattice, whiskers based on Cu-Co-O or Bi-Sr-Co-O, mixed oxides of the general formula (I)

$$SrTiO_mS_n \qquad (I)$$

Where

$0 \leq n \leq 0.2$ and
$2 \leq m \leq 2.99$,

$Ca_2CO_2O_5$, $NaCo_2O_4$, $Ca_2Co_4O_9$, borides, skutterudites, clathrates and bismuth.

11. The use of nanowires according to claim 9 or nanotubes according to claim 10 for thermoelectric heating, for electricity generation, in sensors or for temperature control

**Revendications**

1. Procédé de fabrication de nanofils par le traitement d'une fibre comprenant au moins un matériau de support et au moins un matériau thermoélectriquement actif ou un composé précurseur d'un matériau thermoélectriquement actif, comprenant les étapes consistant à ;

(A) prévoir une fonte ou une solution qui comprend au moins un matériau de support ou des composés précurseurs adéquats du matériau de support et au moins un matériau thermoélectriquement actif ou un composé précurseur d'un matériau thermoélectriquement actif,
(B) filer électriquement la fonte ou la solution issue de l'étape (A), une fibre comprenant au moins un matériau de support et au moins un matériau thermoélectriquement actif ou un composé précurseur d'un matériau thermoélectriquement actif étant obtenue,
(C) éventuellement, enrober la fibre obtenue avec un diélectrique, une fibre électriquement isolée étant obtenue,
(D) éventuellement, faire passer le composé précurseur du matériau thermoélectriquement actif à la forme active,
(E) éventuellement, éliminer le matériau de support, les étapes (C) à (E) pouvant être exécutées dans un ordre quelconque, le matériau thermoelectriquement actif étant au moins un composé comprenant au moins un élément choisi dans le groupe composé du tellure et du bore, ou le matériau thermoélectriquement actif étant choisi dans le groupe composé des antimoniures, des siliciures, des germaniures, des skutterudites, des clathra-

tes, du bismuth, du $NaCO_2O_4$, du $Bi_{2-x}Ph_xSr_2Co_2O_y$ avec x = 0 à 0,6 et y = 8 + σ, des trichites à base de Cu-Co-O ou de Bi-Sr-Co-O, des oxydes mixtes de formule (I)

$$SrTiO_mS_n \qquad (I)$$

avec

$0 \le n \le 0,2$ et
$2 \le m \le 2,99$,

du $Ca_2CO_2O_5$, du $NaCo_2O_4$, du $Ca_2Co_4O_9$ et de leurs mélanges.

2. Procédé de fabrication de nanotubes par le traitement d'une fibre comprenant au moins un matériau de support et au moins un matériau thermoélectriquement actif ou un composé précurseur d'un matériau thermoélectriquement actif, comprenant les étapes consistant à :

(F) prévoir une fonte ou une solution qui comprend au moins un matériau de support ou des composés précurseurs adéquats du matériau de support,
(G) filer électriquement la fonte ou la solution issue de l'étape (F), une fibre composée d'au moins un matériau de support étant obtenue,
(H) enrober la fibre obtenue à l'étape (G) avec au moins un matériau thermoélectriquement actif ou un précurseur d'un matériau thermoélectriquement actif, une fibre comprenant au moins un matériau de support et au moins un matériau thermoélectriquement actif ou un composé précurseur d'un matériau thermoélectriquement actif étant obtenue,
(I) éventuellement, enrober la fibre obtenue avec un diélectrique, une fibre électriquement isolée étant obtenue,
(J) éventuellement, faire passer le composé précurseur du matériau thermoélectriquement actif à la forme active,
(K) éventuellement, éliminer le matériau de support, les étapes (I) à (K) pouvant être exécutées dans un ordre quelconque, le matériau thermoélectriquement actif étant au moins un composé comprenant au moins un élément choisi dans le groupe composé du tellure, de l'antimoine, du silicium et du germanium et/ou le matériau thermoélectriquement actif étant choisi dans le groupe composé des oxydes de cobalt à grille de couches, des trichites à base de Cu-Co-O ou de Bi-Sr-Co-O, des oxydes mixtes de formule générale (I)

$$SrTiO_mS_n \qquad (I)$$

avec

$0 \le n \le 0,2$ et
$2 \le m \le 2,99$,

du $Ca_2CO_2O_5$, du $NaCo_2O_4$, du $Ca_2Co_4O_9$, des borures, des skutterudites, des clathrates et du bismuth.

3. Procédé selon la revendication 1 ou 2, **caractérisé en ce que** le matériau de support est un polymère ou un matériau qui est obtenu par le procédé sol-gel.

4. Procédé selon la revendication 3, **caractérise en ce que** le polymère est un polylactide ou un polyamide.

5. Procédé selon l'une quelconque des revendications 1 à 4, **caractérisé en ce que** le composé précurseur pour le matériau thermoélectriquement actif est un sel ou un complexe du matériau thermoélectriquement actif.

6. Procédé selon l'une quelconque des revendications 1 à 5, **caractérisé en ce que** le matériau thermoélectriquement actif est choisi dans le groupe composé du bismuth, du $Bi_2Te_3$, du PbTe et de leurs mélanges.

7. Procédé selon l'une quelconque des revendications 1 à 6, **caractérisé en ce que** le diélectrique est choisi dans le groupe composé d'homopolymères et de copolymères aromatiques et aliphatiques et de leurs mélanges.

8. Procédé selon la revendication 7, **caractérisé en ce que** le diélectrique est du poly-para-xylylène ou du polytétraflluoréthylène.

**9.** Nanofil, comprenant au moins un matériau thermoélectriquement actif, ayant un diamètre de moins de 200 nm et une longueur d'au moins 10 mm, dans lequel le matériau thermoélectriquement actif est un composé comprenant au moins un élément choisi dans le groupe composé du tellure et du bore, ou le matériau thermoélectriquement actif est choisi dans le groupe composé des antimoniures, des siliciures, des germaniures, des skutterudites, des clathrates, du bismuth, du $NaCO_2O_4$, du $Bi_{2-x}Ph_xSr_2Co_2O_y$ avec x = 0 à 0,6 et y = 8 + σ, des trichites à base de Cu-Co-O ou de Bi-Sr-Co-O, des oxydes mixtes de formule (I)

$$SrTiO_mS_n \qquad (I)$$

avec

$0 \leq n \leq 0,2$ et
$2 \leq m \leq 2,99$,

du $Ca_2CO_2O_5$, du $NaCo_2O_4$, du $Ca_2Co_4O_9$ et de leurs mélanges

**10.** Nanotubes, comprenant au moins un matériau thermoélectriquement actif, ayant un diamètre de moins de 200 nm, une épaisseur de paroi de moins de 30 nm et une longueur d'au moins 1 mm, dans lesquels le matériau thermoélectriquement actif est au moins un composé comprenant au moins un élément choisi dans le groupe composé du tellure, de l'antimoine, du silicium et du germanium et/ou le matériau thermoélectriquement actif est choisi dans le groupe composé des oxydes de cobalt à grille de couches, des trichites à base de Cu-Co-O ou de Bi-Sr-Co-O, des oxydes mixtes de formule générale (I)

$$SrTiO_mS_n \qquad (I)$$

avec

$0 \leq n \leq 0,2$ et
$2 \leq m \leq 2,99$,

du $Ca_2CO_2O_5$, du $NaCo_2O_4$, du $Ca_2Co_4O_9$, des borures, des skutterudites, des clathrates et du bismuth.

**11.** Utilisation de nanofils selon la revendication 9 ou de nanotubes selon la revendication 10 pour l'équilibrage de température thermoélectrique, pour la génération de courant électrique, dans des capteurs ou pour la régulation de température.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10116232 A1

**In der Beschreibung aufgeführte Nicht-Patentliteratur**

- *Physical Review Letters,* vol. 88 (21), 216801-1216801-4
- Thermoelectric Material. Research and Applications
- *Eur. J. Inorg. Chem.,* 2003, 3699-3702
- *Adv. Mater.,* 2003, vol. 15 (5), 353-389
- *Angew. Chem.,* 2004, vol. 116, 1356-1367
- *Adv. Mater.,* 2004, vol. 16 (14), 1151-1169
- **H. K. Schmidt.** Das Sol-Gel-Verfahren. *Chemie in unserer Zeit,* 2001, vol. 35 (3), 176-184
- Chemistry, Physics and Material Science of Thermoelectric Materials Beyond Bismuth Tellurides. Kluwer Academic/Plenum Publishers, 2003, 71-87
- **R. Funahashi et al.** *Jpn. J. Appl. Phys.,* 2000, vol. 39
- Chemistry, Physics and Material Science of Thermoelectric Materials. Kluwer Academic/Plenum Publishers, 121-146
- Clathrate sind in Chemistry, Physics and Material Science of Thermoelectric Materials. Kluwer Academic/Plenum Publishers, 107-121
- *J. Am. Chem. Soc.,* 1992, vol. 114, 7295-7296
- *Chem. Mater.,* 1992, vol. 4, 24-27
- *Chem. Mater.,* 1992, vol. 4, 894-899
- *Adv. Mater.,* vol. 16 (14), 1151-1169
- **R. Dersch et al.** *J. Polym. Sci. Part A: Pol. Chem.,* 2003, vol. 41, 545-553
- *Adv. Mate,* 2004, vol. 16 (14), 1151-1169